# FASCICULE DE BREVET EUROPEEN

(11) **EP 0 846 957 B1**
(45) Date de publication et mention de la délivrance du brevet: **05.06.2002**
(21) Numéro de dépôt: 97440118.4
(22) Date de dépôt: 27.11.1997
(51) Int. Cl.: G01R 33/02

(54) **Dispositif de mesure et de surveillance de l'intensité d'un champ magnétique local et appareil comportant un tel dispositif**
Vorrichtung zum Messen der lokale Magnetische Feldstärke und Anlage mit dieser Vorrichtung
Device for measuring and monitoring the local magnetic field strength and instrument incorporating such a device

(30) Priorité: 29.11.1996 FR 9614836
(43) Date de publication de la demande: 10.06.1998
(73) Titulaire: Bruker Medical SA, 67160 Wissembourg (DE)
(72) Inventeur: Kraemer, Michel, 67360 Durrenbach (FR); Aubrion, Pierre, 67160 Wissembourg (FR); Muller, Gérard, 57410 Rohrbach-Les-Bitche (FR)
(74) Mandataire: Metz, Paul

(56) Documents cités:
- US-A- 4 954 812
- US-A- 5 218 298
- US-A- 5 532 681
- US-A- 5 629 622
- CAVAGNETTO F ET AL: "A PERSONAL DOSIMETER PROTOTYPE FOR STATIC MAGNETIC FIELDS" HEALTH PHYSICS, vol. 65, no. 2, 1 août 1993, pages 172-177, XP000388372

## Description

La présente invention concerne le domaine des appareils et des instruments destinés à être mis en oeuvre dans des environnements magnétiques et a pour objet un dispositif de mesure et de surveillance de l'intensité d'un champ magnétique local et un appareil intégrant un tel dispositif.

Les problèmes liés à l'utilisation d'appareils ou d'instruments électriques dans une région ou une zone magnétiquement chargée sont bien connus.

En plus de la perturbation du champ magnétique environnant que provoquent ces appareils ou instruments, on constate également, de manière réciproque et sous l'influence dudit champ, des dysfonctionnements, voire des détériorations desdits instruments ou appareils, en fonction de l'intensité dudit champ et de la situation spatiale des instruments ou appareils par rapport à ce dernier.

Les risques précités sont particulièrement élevés pour des appareils ou des instruments non fixes que les utilisateurs peuvent déplacer à leur gré et qui peuvent éventuellement être installés involontairement dans une zone sensible sans qu'il n'y ait un quelconque avertissement ou une quelconque indication visible évidente au niveau de l'appareil ou de l'instrument concerné.

De telles manipulations dangereuses desdits appareils ou instruments peuvent, en outre, être réalisées a priori en toute innocuité, lorsque l'appareil ou l'instrument est éteint ou lorsque le champ magnétique n'est pas établi, pour entraîner ensuite des dommages ou des détériorations importants pour ledit appareil ou ledit instrument, lorsque ce dernier est mis en service ou lorsque le champ est rétabli.

Par ailleurs, il y a lieu de noter que, pour les appareils de surveillance des paramètres physiologiques vitaux d'un patient, par exemple soumis à un examen IRM, un simple dysfonctionnement d'un composant ou d'un élément d'un tel appareil, susceptible d'entraîner l'affichage de signaux erronés, peut avoir des conséquences fatales.

Le but de la présente invention consiste, par conséquent, notamment à pallier lcs différents inconvénients précités et à proposer une solution fiable dans toutes les situations mentionnés précédemment, de structure simple et peu onéreuse.

Par le document US-A-4 954 812, on connaît un dispositif de mesure et de surveillance correspondant sensiblement à celui défini par le préambule de la revendication 1.

Toutefois, ce dispositif ne comporte aucun moyen permettant d'assurer sa protection dans les situations précitées.

La présente invention permet de pallier cette limitation en prévoyant les moyens exposés dans la partie caractérisante de la revendication 1.

L'invention a également pour objet un appareil destiné à être mis en oeuvre à proximité d'un champ magnétique, notamment appareil de surveillance des paramètres physiologiques d'un patient soumis à un examen du type IRM, comportant un dispositif de mesure et de surveillance de l'intensité du champ magnétique au niveau dudit appareil, tel que mentionné ci-dessus.

L'invention sera mieux comprise, grâce à la description ci-après, qui se rapporte à un mode de réalisation préféré, donné à titre d'exemple non limitatif, et expliqué avec référence aux dessins schématiques annexés, dans lesquels :
la figure 1 est un schéma synoptique d'un dispositif de mesure et de surveillance selon l'invention,
la figure 2 est un schéma synoptique d'un mode de réalisation des moyens de traitement et d'évaluation des signaux délivrés par les moyens capteurs, faisant partie du dispositif représenté à la figure 1, et,
la figure 3 est une vue partiellement arrachée d'un appareil de surveillance des paramètres physiologiques vitaux d'un patient, montrant l'implantation des éléments et circuits dissipateurs de chaleur.

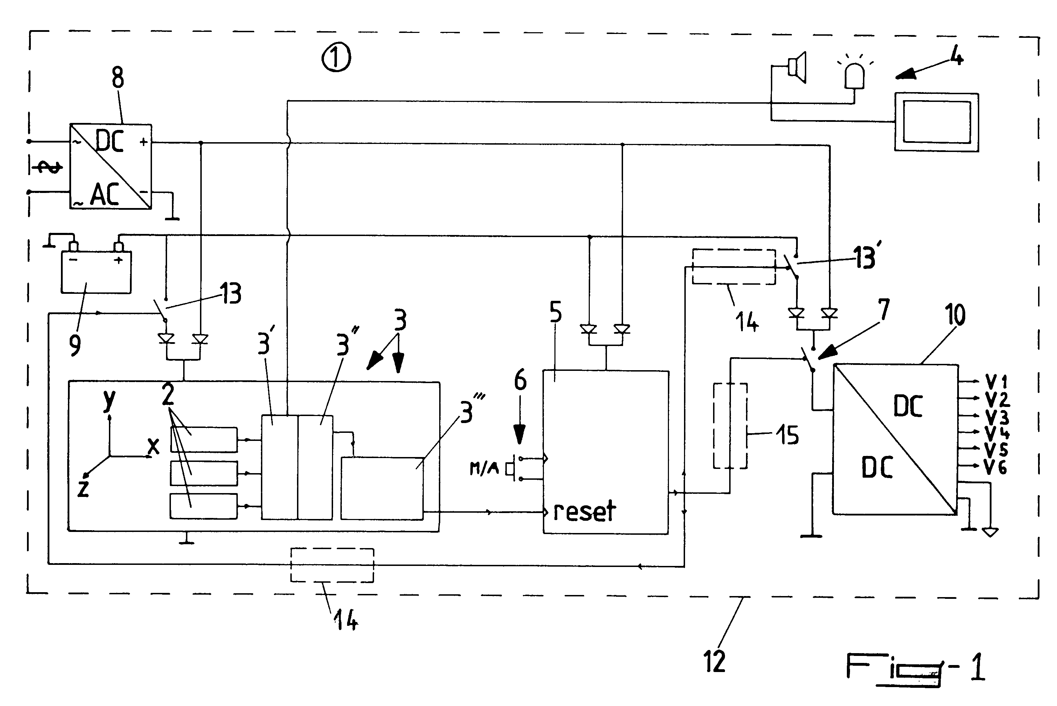

Conformément à l'invention et comme le montre la figure 1 des dessins annexés, le dispositif de mesure et de surveillance de l'intensité d'un champ magnétique local est monté dans ou sur un appareil ou un instrument I destiné à être positionné à proximité d'un appareil produisant un champ magnétique intense et sensible, tel qu'un appareil à RMN, et constitué par des moyens 2 capteurs de champ magnétique, par des moyens 3 de traitement et d'évaluation des signaux de mesure délivrés par les moyens capteurs 2 et par des moyens de signalisation 4 et de contrôle 5 de l'alimentation ou du fonctionnement dudit appareil ou instrument 1, commandés par lesdits moyens 3 de traitement et d'évaluation.

Afin de pouvoir assurer une détermination de l'intensité du champ magnétique quelle que soit l'orientation de l'appareil ou de l'instrument 1, les moyens capteurs 2 sont avantageusement constitués par trois capteurs à effet Hall orientés suivant les trois directions d'un repère spatial orthogonal.

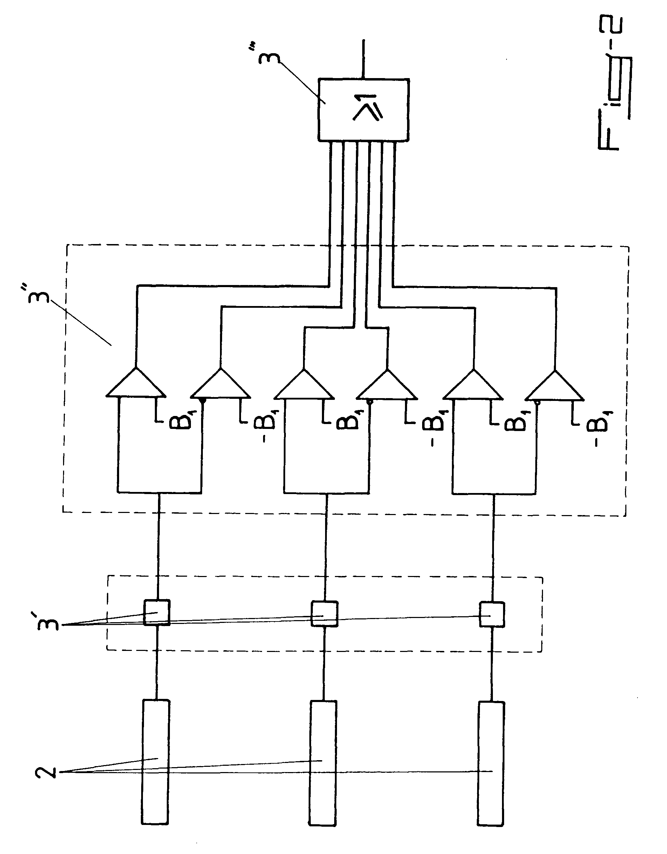

Selon une première caractéristique de l'invention, représentée aux figures 1 et 2 des dessins annexés, les moyens 3 d'évaluation et de traitement des signaux fournis par les moyens capteurs 2 peuvent comprendre des circuits 3' d'extraction des composantes représentatives du champ magnétique des signaux délivrés par les moyens capteurs 2, des circuits de comparaison 3" desdits signaux représentatifs et des signaux opposés correspondants avec des valeurs seuil prédéfinies et une unité 3"' de synthèse logique des signaux résultant des comparaisons précitées, délivrant un signal de commande de l'alimentation ou du fonctionnement de l'appareil ou de l'instrument 1 considéré, lesdits moyens 3 étant constitués de composants électroniques introduisant des retards de traitement et d'évaluation de faible valeur.

Ainsi, le traitement et l'évaluation des signaux émis par les moyens capteurs 2 sont réalisés entièrement par un circuit matériel ("hardware"), permettant de réduire au maximum le délai entre la mesure d'un champ magnétique de valeur trop forte et la délivrance d'un signal discontinu au niveau de la sortie de l'unité 3"' de synthèse logique.

Ainsi, les trois moyens capteurs 2 orthogonaux, associés aux moyens 3 de traitement et d'évaluation, permettent de déterminer les modules des composantes constitutives du vecteur du champ magnétique local selon les trois directions orthogonales définies par les trois moyens capteurs 2 et lesdits moyens 3 3 peuvent délivrer des signaux de commande aux moyens de signalisation 4 et de contrôle 5 lorsque le module de l'une de ces composantes de champ dépasse une valeur seuil prédéfinie, par exemple la valeur maximale admise pour un fonctionnement fiable du composant, élément ou circuit de l'appareil ou de l'instrument 1 le plus sensible aux influences magnétiques.

Les moyens de signalisation 4 pourront comporter, d'une part, des moyens d'alarme sonore et/ou visuelle et, d'autre part, un écran d'affichage de la valeur du champ magnétique local au niveau de l'appareil ou de l'instrument 1, à titre permanent ou sur requête de l'utilisateur, ladite valeur étant déterminée par calcul à partir des modules des composantes mesurées par les moyens capteurs 2.

Ledit écran ou partie d'écran pourra également, le cas échéant, afficher un message d'alarme indiquant la présence d'un champ magnétique susceptible de perturber le fonctionnement de l'appareil ou de l'instrument 1.

Les circuits d'extraction 3' peuvent comprendre notamment des circuits de compensation ou d'annulation de la tension de décalage (offset) des moyens capteurs 2 et, le cas échéant, des circuits de mise en forme des signaux délivrés par ces derniers.

Comme le montre la figure 2 des dessins annexés, l'unité 3"' de synthèse logique peut consister en un simple circuit OU ou en un circuit à fonction similaire.

Conformément à une autre caractéristique de l'invention, les moyens 5 de contrôle de l'alimentation ou du fonctionnement de l'appareil ou de l'instrument 1 consistent préférentiellement en un module de contrôle automatique adapté pour valider, inhiber et/ou invalider le signal de mise en marche ou l'état de marche dudit appareil ou instrument 1, ledit module 5 recevant, d'une part, le signal de mise en service ou hors service délivré par un organe 6 correspondant pouvant être actionné par l'utilisateur et, d'autre part, le signal de commande délivré par les moyens 3 de traitement et d'évaluation, et pouvant délivré à son tour un signal d'autorisation de mise sous tension de l'appareil ou de l'instrument 1 en fonction de la nature des signaux reçus.

Comme le montre également la figure 1 des dessins annexés, le signal d'autorisation délivré par le module de contrôle 5 est appliqué à un moyen interrupteur 7 disposé en série entre la ou les sources d'énergie électrique 8, 9 et l'unité 10 de conversion et de distribution d'énergie électrique aux différents circuits fonctionnels faisant partie de l'appareil ou de l'instrument 1 considéré.

Selon un mode de réalisation préférentiel de l'invention, les moyens 5 de contrôle de l'alimentation ou du fonctionnement et l'unité 10 de conversion et de distribution d'énergie électrique sont connectés par l'intermédiaire de deux circuits d'alimentation parallèles, d'une part, à un accumulateur ou à une batterie 9 et, d'autre part, à un ensemble transformateur/redresseur 8 relié au secteur, intégrés dans la structure de l'appareil ou de l'instrument 1, l'alimentation des moyens 3 de traitement et d'évaluation et de l'unité de conversion et de distribution 10 à partir de l'accumulateur ou de la batterie 9 étant assujettie à la délivrance d'un signal d'autorisation par le module de contrôle 5, ce signal d'autorisation étant inhibé lorsque l'appareil ou l'instrument 1 est alimenté par le secteur (indiqué par les repères 14 sur la figure 1).

On notera que grâce aux dispositions précitées, le module de contrôle automatique 5 est alimenté en permanence ce quel que soit le mode d'alimentation (secteur ou batterie), et peut donc délivrer un signal d'autorisation de mise sous tension dès l'actionnement de l'organe 6 de mise en marche (par exemple sous forme de bouton poussoir) par l'utilisateur, ce pour autant qu'aucun signal d'inhibition ou d'invalidation ne soit présent à la sortie de l'unité de synthèse logique 3"' des moyens 3 de traitement et d'évaluation.

Ces derniers sont alimentés en permanence lorsque l'appareil ou l'instrument 1 est branché sur le secteur, mais ne sont alimentés qu'après délivrance d'un signal d'autorisation de mise sous tension par le module de contrôle automatique 5 lorsque l'appareil ou l'instrument 1 fonctionne sur batterie ou accumulateur.

Dans ce dernier cas, le signal d'autorisation de mise sous tension délivré par le module de contrôle automatique 5 est appliqué simultanément au moyen interrupteur 13 commandant l'alimentation des moyens de traitement et d'évaluation 3 et aux moyens interrupteurs 7 et 13' commandant l'alimentation de l'unité 10 de conversion et de distribution de l'énergie électrique.

Toutefois, les moyens de traitement et d'évaluation 3 étant entièrement composés de circuits analogiques, l'évaluation de l'intensité du champ magnétique sera effectuée pratiquement instantanément et l'émission éventuelle d'un signal d'invalidation ou d'inhibition en cas de dépassement d'un seuil précédera dans tous les cas l'établissement des tensions à la sortie de l'unité 10 de conversion et de distribution de l'énergie électrique, ce qui permettra par conséquent, le cas échéant, de stopper la mise sous tension des éléments des circuits fonctionnels de l'appareil ou de l'instrument 1 avant toute détérioration.

Les différents modes de manipulation et d'utilisation de l'appareil ou de l'instrument 1 et les réactions éventuelles correspondantes du dispositif de mesure et de surveillance du champ magnétique local entourant l'appareil ou l'instrument 1 dans lequel il est implanté, seront décrits plus en détail ci-après.

Lorsque l'appareil ou l'instrument 1 est, à l'état éteint et en étant branché sur le secteur, placé dans une zone où le champ magnétique environnant est trop élevé : toute mise en marche dudit appareil ou instrument 1 sera impossible.

Lorsque l'appareil ou l'instrument 1 est, à l'état éteint et en étant alimenté par l'accumulateur ou la batterie 9, placé dans une zone où le champ magnétique environnant est trop élevé, l'actionnement de l'organe de mise en marche 6 par l'utilisateur entraînera une mise en marche temporaire, dont la durée équivaut au temps nécessaire à la stabilisation des moyens 3 de traitement et d'évaluation et à l'émission d'un signal d'inhibition ou d'invalidation vers le module de contrôle automatique 5, qui commandera alors l'ouverture des moyens interrupteurs 7, 13 et 13' et la mise hors tension ou hors service dudit appareil ou instrument 1.

En vue de garantir un contrôle de l'intensité du champ magnétique avant toute mise sous tension des circuits ou éléments fonctionnels de l'appareil ou instrument 1, il peut être avantageusement prévu que le signal d'autorisation délivré par le module de contrôle 5 soit transmis au moyen interrupteur 7 commandant l'alimentation de l'unité de conversion et de distribution 10 avec un retard prédéterminé (indiqué par le repère 15 sur la figure 1), suffisamment faible pour qu'en cas de mise en route normale autorisée, l'utilisateur ne remarque pas de délai notable entre l'actionnement de l'organe de mise en marche 6 et la mise en service de l'appareil ou de l'instrument 1.

Lorsque l'appareil ou l'instrument 1 est mis en service dans une zone non critique et qu'il est progressivement rapproché ou introduit dans une zone où le champ magnétique environnant est trop élevé, les moyens de signalisation 4 indiquent tout d'abord à l'utilisateur la présence d'un champ magnétique de valeur critique pour le fonctionnement de l'appareil ou l'instrument 1, et, en cas de dépassement de la valeur seuil, l'état de marche de ce dernier sera invalidé par commande de l'ouverture des moyens interrupteurs 7, 13 et 13' de manière à mettre hors tension les différents circuits et éléments dudit appareil ou instrument 1.

La réalisation pratique des différents moyens de 2, 3, 4 et 5 constituant le dispositif selon l'invention, faisant partie des connaissances normales de l'homme du métier, celle-ci ne sera pas davantage décrite dans la présente.

L'invention a également pour objet un appareil destiné à être mis en oeuvre à proximité d'un champ magnétique, notamment un appareil de surveillance des paramètres physiologiques d'un patient soumis à un examen du type IRM, caractérisé en ce qu'il comporte un dispositif de mesure et de surveillance de l'intensité du champ magnétique au niveau dudit appareil, tel que décrit précédemment.

L'appareil de surveillance précité pourra notamment être relié à un capteur de SpO₂ capteur mesurant le taux de saturation en O₂ de l'hémoglobine dans le sang à fibre optique et à un capteur de température par fibre optique.

De manière avantageuse, l'alimentation électrique de l'appareil 1 par le secteur est réalisée par l'intermédiaire d'un ensemble transformateur/redresseur suivi d'une unité 10 de conversion et de distribution de l'énergie électrique, disposés de telle manière dans l'appareil 1 que les axes des bobines de ces éléments 8, 10 soient orientés perpendiculairement à l'axe du champ magnétique environnant lorsque ledit appareil 1 est installé dans sa position d'utilisation normale.

Cette disposition particulière des éléments précités permet de limiter les effets de saturation produits par le champ magnétique local dans lequel l'appareil 1 est placé et donc d'augmenter le rendement desdits éléments et de limiter leur échauffement.

Conformément à un mode de réalisation préférentiel de l'invention, l'unité 10 de conversion et de distribution de l'énergie électrique, qui assure la fourniture des diverses tensions nécessaires aux différents circuits et éléments fonctionnels de l'appareil 1, est constituée par un convertisseur DC/DC, qui présente l'avantage d'une dissipation calorique réduite en fonctionnement, ce contrairement aux régulateurs linéaires.

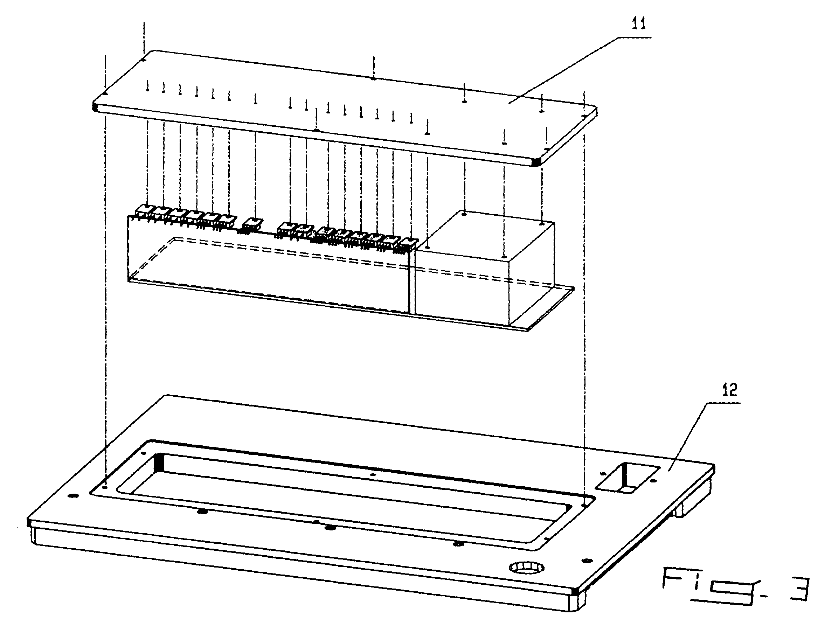

Selon une caractéristique supplémentaire de l'invention, représentée notamment à la figure 3 des dessins annexés, il peut être prévu qu'au moins certains éléments ou circuits dissipateurs de chaleur faisant partie de l'appareil 1, notamment l'ensemble transformateur/redresseur 8 et l'unité 10 de conversion et de distribution d'énergie électrique, soient regroupés sur un support 11 réalisé en un matériau bon conducteur thermique et fixé intimement au blindage 12 entourant l'appareil 1.

Comme le montre, à titre d'exemple, la figure 3 des dessins annexés, le support 11 peut consister en une plaque de blindage rapportée sur une ouverture ménagée dans le blindage 12 et fixée sur cette dernière avec un contact surfacique intime.

Ainsi, il n'est plus nécessaire de disposer d'un élément actif (par exemple un ventilateur) pour évacuer ou dissiper les calories produites par ces éléments ou circuits, ni de réaliser des perçages dans la carcasse et le blindage 12 entourant l'appareil 1. La possibilité de pouvoir évacuer les calories produites par ces éléments ou circuits dissipateurs de chaleur par les moyens décrits ci-dessus bénéficie, bien entendu, également de la caractéristique précédente relative à la disposition particulière de ces éléments ou circuits.

Il convient de noter que les deux dernières caractéristiques mentionnées ci-dessus pourront également être mises en oeuvre dans un appareil 1 indépendamment de la présence d'un dispositif de mesure et de surveillance d'un champ magnétique local tel que décrit ci-dessus.

Bien entendu, l'invention n'est pas limitée au mode de réalisation décrit et représenté aux dessins annexés. Des modifications restent possibles, notamment du point de vue de la constitution des divers éléments ou par substitution d'équivalents techniques, sans sortir pour autant du domaine de protection de l'invention.

## Revendications

1. Dispositif de mesure et de surveillance de l'intensité d'un champ magnétique local, monté dans ou sur un appareil ou un instrument (1) destiné à être positionné à proximité d'un appareil produisant un champ magnétique tel qu'un appareil à RMN, et constitué par des moyens (2) capteurs de champ magnétique et par des moyens (3) de traitement et d'évaluation des signaux de mesure délivrés par les moyens capteurs (2), dispositif **caractérisé en ce qu'**il comprend également des moyens de signalisation (4) et de contrôle (5) de l'alimentation ou du fonctionnement dudit appareil ou instrument (1), commandés par lesdits moyens (3) de traitement et d'évaluation.

2. Dispositif selon la revendication 1, **caractérisé en ce que** les moyens capteurs (2) sont constitués par trois capteurs à effet Hall orientés suivant les trois directions d'un repère spatial orthogonal.

3. Dispositif selon l'une quelconque des revendications 1 et 2, **caractérisé en ce que** les moyens (3) d'évaluation et de traitement des signaux fournis par les moyens capteurs (2) comprennent des circuits (3') d'extraction des composantes représentatives du champ magnétique des signaux délivrés par les moyens capteurs (2), des circuits de comparaison (3") desdits signaux représentatifs et des signaux opposés correspondants avec des valeurs seuil prédéfinies et une unité (3"') de synthèse logique des signaux résultant des comparaisons précitées, délivrant un signal de commande de l'alimentation ou du fonctionnement de l'appareil ou de l'instrument (1) considéré, lesdits moyens (3) étant constitués de composants électroniques introduisant des retards de traitement et d'évaluation de faible valeur.

4. Dispositif selon l'une quelconque des revendications 1 à 3, **caractérisé en ce que** les moyens (5) de contrôle de l'alimentation ou du fonctionnement de l'appareil ou de l'instrument (1) consistent en un module de contrôle automatique adapté pour valider, inhiber et/ou invalider le signal de mise en marche ou l'état de marche de ce dernier, ledit module de contrôle automatique (5) recevant, d'une part, le signal de mise en service ou hors service délivré par un organe (6) correspondant pouvant être actionné par l'utilisateur et, d'autre part, le signal de commande délivrer par les moyens (3) de traitement et d'évaluation, et pouvant délivré à son tour un signal d'autorisation de mise sous tension de l'appareil ou de l'instrument (1) en fonction de la nature des signaux reçus.

5. Dispositif selon la revendication 4, **caractérisé en ce que** le signal d'autorisation délivré par le module de contrôle (5) est appliqué à un moyen interrupteur (7) disposé en série entre la ou les sources d'énergie électrique (8, 9) et l'unité (10) de conversion et de distribution d'énergie électrique aux différents circuits fonctionnels faisant partie de l'appareil ou de l'instrument (1) considéré.

6. Dispositif selon la revendication 5, **caractérisé en ce que** les moyens (3) de traitement et d'évaluation, les moyens (5) de contrôle de l'alimentation ou du fonctionnement et l'unité (10) de conversion et de distribution d'énergie électrique sont connectés par l'intermédiaire de deux circuits d'alimentation parallèles, d'une part, à un accumulateur ou à une batterie (9) et, d'autre part, à un ensemble transformateur/redresseur (8) relié au secteur, intégrés dans la structure de l'appareil ou de l'instrument (1), l'alimentation électrique des moyens (3) de traitement et d'évaluation et de l'unité de conversion et de distribution (10) à partir de l'accumulateur ou de la batterie (9) étant assujettie à la délivrance d'un signal d'autorisation par le module de contrôle (5), ce signal d'autorisation étant inhibé lorsque l'appareil ou l'instrument (1) est alimenté par le secteur.

7. Dispositif selon l'une quelconque des revendications 5 et 6, **caractérisé en ce que** le signal d'autorisation délivré par le module de contrôle (5) est transmis au moyen interrupteur (7) commandant l'alimentation de l'unité de conversion et de distribution (10) avec un retard prédéterminé.

8. Appareil destiné à être mis en oeuvre à proximité d'un champ magnétique, notamment appareil de surveillance des paramètres physiologiques d'un patient soumis à un examen du type IRM, **caractérisé en ce qu'**il comporte un dispositif de mesure et de surveillance de l'intensité du champ magnétique au niveau dudit appareil, selon l'une quelconque des revendications 1 à 7.

9. Appareil selon la revendication 8, **caractérisé en ce que** l'alimentation électrique de l'appareil (1) par le secteur est réalisée par l'intermédiaire d'un ensemble transformateur/redresseur (8) suivi d'une unité de conversion et de distribution (10) de l'énergie électrique, disposés de telle manière dans l'appareil (1) que les axes des bobines de ces éléments (8, 10) soient orientés perpendiculairement à l'axe du champ magnétique environnant lorsque ledit appareil (1) est installé dans sa position d'utilisation normale.

10. Appareil selon la revendication 9, **caractérisé en ce que** l'unité (10) de conversion et de distribution de l'énergie électrique est constituée par un convertisseur DC/DC.

11. Appareil selon l'une quelconque des revendications 8 à 10, **caractérisé en ce que** au moins certains éléments ou circuits dissipateurs de chaleur faisant partie de l'appareil (1), notamment l'ensemble transformateur/redresseur (8) et l'unité (10) de conversion et de distribution d'énergie électrique, sont regroupés sur un support (11) réalisé en un matériau bon conducteur thermique et fixé intimement au blindage (12) entourant l'appareil (1).

## Patentansprüche

1. Vorrichtung zum Messen und Überwachen der Stärke eines lokalen Magnetfeldes, die in oder auf einem Gerät oder Instrument (1) angeordnet ist, das zum Positionieren in der Nähe eines ein Magnetfeld erzeugenden Geräts, wie eines NMR-Geräts, ausgebildet ist und das Magnetfeldsensoren (2) sowie Signalverarbeitungs- und Signalauswertemittel (3) für von den Sensoren (2) gelieferte Meßsignale aufweist, **gekennzeichnet durch** Anzeigemittel (4) und Kontrollmittel (5) für die Versorgung oder den Betrieb des Geräts oder des Instruments (1), die **durch** die Verarbeitungs- und Auswertemittel (3) steuerbar sind.

2. Vorrichtung nach Anspruch 1, **dadurch gekennzeichnet, daß** die Sensoren (2) aus drei Hall-Sonden gebildet sind, die in Richtung der drei Achsen eines kartesischen Koordinatensystems orientiert sind.

3. Vorrichtung nach Anspruch 1 oder 2, **dadurch gekennzeichnet, daß** die Verarbeitungs- und Auswertemittel (3) für die von den Sensoren (2) gelieferten Signale Schaltkreise (3') zur Gewinnung repräsentativer Anteile des Magnetfeldes aus den von den Sensoren (2) gelieferten Signalen, Komparatorkreise (3'') zum Vergleichen der repräsentativen Signale mit Gegensignalen, die mit vorbestimmten Schwellenwerten übereinstimmen, und eine logische Synthese-Einheit (3''') für aus dem Vergleich resultierende Signale aufweisen, die ein Steuersignal für die Versorgung oder den Betrieb des Geräts oder des Instruments (1) liefern, wobei die Mittel (3) aus elektronischen Bauteilen gebildet sind, durch die geringe Verzögerungen der Verarbeitung und Auswertung bewirkt sind.

4. Vorrichtung nach einem der Ansprüche 1 bis 3, **dadurch gekennzeichnet, daß** die Kontrollmittel (5) für die Versorgung oder den Betrieb des Geräts oder des Instruments (1) durch ein automatisches Kontrollmodul gebildet sind, das zum Bestätigen, Verzögern und/oder Unwirksammachen des Inbetriebnahme-Signals oder des Betriebszustands des Geräts oder des Instruments (1) ausgebildet ist, wobei an dem automatischen Kontrollmodul (5) einerseits das von einer entsprechenden, durch den Benutzer betätigbaren Einrichtung (6) gelieferte Anschalt- oder Ausschaltsignal, andererseits das von den Verarbeitungs- und Auswertemitteln (3) gelieferte Steuersignal anliegt und wobei durch das Kontrollmodul (5) selbst ein Spannungs-Freigabesignal für das Gerät oder das Instrument (1) in Abhängigkeit von der Art der empfangenen Signale lieferbar ist.

5. Vorrichtung nach Anspruch 4, **dadurch gekennzeichnet, daß** das vom Kontrollmodul (5) gelieferte Freigabesignal auf ein Schaltmittel (7) anwendbar ist, das in Serie zwischen der elektrischen Energiequelle oder den elektrischen Energiequellen (8,9) und der Energie-Umwandlungs- und -Versorgungseinheit (10) angeordnet ist, die zur elektrischen Energieversorgung der verschiedenen funktionellen Schaltkreise, die Bestandtelle des betrachteten Geräts oder Instruments (1) sind, ausgebildet ist.

6. Vorrichtung nach Anspruch 5, **dadurch gekennzeichnet, daß** die Verarbeitungs- und Auswertemittel (3), die Kontrollmittel (5) für die Versorgung oder den Betrieb und die Energie-Umwandlungs- und -Versorgungseinheit (10) über zwei in die Struktur des Geräts oder des Instruments (1) integrierte parallele Versorgungs-Schaltkreise einerseits mit einem Akkumulator oder einer Batterie (9), andererseits mit einer an das Netz angeschlossenen Transformator-/Gleichrichter-Anordnung (8) verbunden sind, wobei die elektrische Versorgung der Verarbeitungs- und Auswertemittel (3) und der Energie-Umwandlungs- und Versorgungseinheit (10) durch den Akkumulator oder die Batterie (9) von der Bereitstellung eines Freigabesignals durch das Kontrollmodul (5) abhängig ist, wobei kein Freigabesignal ergeht, wenn das Gerät oder Instrument (1) über das Netz versorgt ist.

7. Vorrichtung nach Anspruch 5 oder 6, **dadurch gekennzeichnet, daß** das vom Kontrollmodul (5) gelieferte Freigabesignal zum Schaltmittel (7) leitbar ist, das die Versorgung der Energie-Umwandlungs- und -Versorgungseinheit (10) mit einer vorbestimmten Verzögerung steuert.

8. Gerät zur Benutzung in der Nähe eines Magnetfeldes, insbesondere Gerät zum Überwachen physiologischer Parameter eines Patienten, der einer Untersuchung nach Art der Kernspintomographie unterzogen ist, **gekennzeichnet durch** eine Meß- und Überwachungs-Vorrichtung für die Stärke des Magnetfelds am Ort des Geräts nach einem der Ansprüche 1 bis 7.

9. Gerät nach Anspruch 8, **dadurch gekennzeichnet, daß** die elektrische Versorgung des Geräts (1) über das Netz mittels einer Transformator-/Gleichrichter-Anordnung (8) und einer dieser nachgeschalteten Energie-Umwandlungs- und -Versorgungseinheit (10) realisiert ist, die derart innerhalb des Geräts (1) angeordnet sind, daß die Spulenachsen der Elemente (8,10) senkrecht zur Achse des umgebenden Magnetfelds orientiert sind, wenn das Gerät (1) in seiner normalen Gebrauchsstellung angebracht ist.

10. Gerät nach Anspruch 9, **dadurch gekennzeichnet, daß** die Energie-Umwandlungs- und Versorgungseinheit (10) mittels eines Gleichumrichters gebildet ist.

11. Gerät nach einem der Ansprüche 8 bis 10, **dadurch gekennzeichnet, daß** wenigstens einige wärmeerzeugende Elemente oder Schaltkreise, die Bestandteile des Geräts (1) sind, insbesondere die Transformator-/Gleichrichter-Anordnung (8) und die Energie-Umwandlungs- und - Versorgungseinheit (10), gemeinsam auf einer Halteeinrichtung (11) angeordnet sind, die aus einem Material mit guter Wärmeleitfähigkeit besteht und an der das Gerät (1) umgebenden Abschirmung (12) satt befestigt ist.

## Claims

1. Device for measuring and monitoring the intensity of a local magnetic field, which device is mounted in or on an apparatus or instrument (1) to be positioned close to an apparatus producing a magnetic field, such as an NMR apparatus, and which is composed of magnetic field sensor means (2) and means (3) for processing and evaluating measuring signals delivered by the sensor means (2), which device is **characterised in that** it also comprises indicator means (4) and control means (5) for the supply to or the operation of said apparatus or instrument (1), controlled by said processing and evaluation means (3).

2. Device according to claim 1, **characterised in that** the sensor means (2) are composed of three Hall effect sensors oriented according to the three directions of an orthogonal spatial reference.

3. Device according to any one of claims 1 and 2, **characterised in that** the means (3) for evaluating and processing the signals supplied by the sensor means (2) comprise circuits (3') for extracting the components that are representative of the magnetic field from the signals delivered by the sensor means (2), circuits (3") for comparing said representative signals and opposite signals corresponding to pre-defined threshold values, and a unit (3"') for logical synthesis of the signals resulting from the abovementioned comparisons, delivering a signal for controlling the supply to or the operation of the apparatus or instrument (1) in question, said means (3) being composed of electronic components that introduce processing and evaluation delays of small value.

4. Device according to any one of claims 1 to 3, **characterised in that** the means (5) for controlling the supply to or the operation of the apparatus or instrument (1) consist of an automatic control module which is capable of validating, inhibiting and/or invalidating the start-up signal or the state of operation of the latter, said automatic control module (5) receiving, on the one hand, the start-up or shut-down signal delivered by a corresponding member (6) that can be actuated by the operator and, on the other hand, the control signal delivered by the processing and evaluation means (3), and being able in turn to deliver a signal authorising the supply of power to the apparatus or instrument (1) according to the nature of the signals received.

5. Device according to claim 4, **characterised in that** the authorisation signal delivered by the control module (5) is applied to a switch means (7) arranged in series between the electric energy source(s) (8, 9) and the unit (10) for the conversion and distribution of electric energy to the various functional circuits forming part of the apparatus or instrument (1) in question.

6. Device according to claim 5, **characterised in that** the processing and evaluation means (3), the means (5) for controlling the supply or operation, and the unit (10) for the conversion and distribution of electric energy are connected by way of two parallel feed circuits on the one hand to an accumulator or to a battery (9) and on the other hand to a transformer/rectifier assembly (8) connected to the mains, integrated into the structure of the apparatus or instrument (1), the supply of power to the processing and evaluation means (3) and to the conversion and distribution unit (10) from the accumulator or the battery (9) being subject to the delivery of an authorisation signal by the control module (5), that authorisation signal being inhibited when the apparatus or instrument (1) is supplied by the mains.

7. Device according to any one of claims 5 and 6, **characterised in that** the authorisation signal delivered by the control module (5) is transmitted with a predetermined delay to the switch means (7) controlling the supply to the conversion and distribution unit (10).

8. Apparatus that is to be used close to a magnetic field, especially an apparatus for monitoring the physiological parameters of a patient undergoing an MRI-type examination, **characterised in that** it comprises a device for measuring and monitoring the intensity of the magnetic field at the level of said apparatus, according to any one of claims 1 to 7.

9. Apparatus according to claim 8, **characterised in that** the supply of power to the apparatus (1) from the mains is effected by way of a transformer/rectifier assembly (8) followed by a unit (10) for the conversion and distribution of the electric energy, which assembly and unit are arranged in the apparatus (1) in such a manner that the axes of the coils of those elements (8, 10) are oriented perpendicularly to the axis of the surrounding magnetic field when said apparatus (1) is installed in its usual operating position.

10. Apparatus according to claim 9, **characterised in that** the unit (10) for the conversion and distribution of electric energy is composed of a DC/DC converter.

11. Apparatus according to any one of claims 8 to 10, **characterised in that** at least some heat-dissipating elements or circuits forming part of the apparatus (1), especially the transformer/rectifier assembly (8) and the unit (10) for the conversion and distribution of electric energy, are grouped on a support (11) which is made of a material that is a good conductor of heat and which is fixed intimately to the casing (12) surrounding the apparatus (1).
